(19) Europäisches Patentamt
European Patent Office
Office européen des brevets

(11) **EP 4 560 921 A1**

(12) **EUROPEAN PATENT APPLICATION**
published in accordance with Art. 153(4) EPC

(43) Date of publication:
**28.05.2025 Bulletin 2025/22**

(51) International Patent Classification (IPC):
*H03K 17/687* (2006.01)    *H03K 17/10* (2006.01)

(21) Application number: 23842285.1

(22) Date of filing: **18.07.2023**

(86) International application number:
**PCT/CN2023/107822**

(87) International publication number:
**WO 2024/017222 (25.01.2024 Gazette 2024/04)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **18.07.2022  CN 202210845163**

(71) Applicant: **Shanghai Vanchip Technologies Co., Ltd.
Shanghai 201203 (CN)**

(72) Inventors:
• **WANG, feng**
  **Shanghai 201203 (CN)**
• **LI, Yanli**
  **Shanghai 201203 (CN)**

(74) Representative: **Wang, Bo**
**Panovision IP**
**Ebersberger Straße 3**
**85570 Markt Schwaben (DE)**

(54) **HIGH-LINEARITY RADIO FREQUENCY SWITCH CIRCUIT, CHIP AND ELECTRONIC DEVICE HAVING SAME**

(57)    A high-linearity radio frequency switch circuit, a chip and an electronic device having same, which can relieve the nonlinear problem of radio frequency switch circuits, and improve the withstand power and the voltage withstanding capability of same. The radio frequency switch circuit consists of multiple stages of switching transistor units connected in series, wherein of each switching transistor (Mi), a gate is connected to a corresponding gate bias resistor (RAi), a drain and a source are separately connected to a corresponding via resistor (Rdsi), and a body is connected to a corresponding body bias resistor (RBi); the gate bias resistor (RAi) and the body bias resistor (RBi) in a switching transistor unit of each stage are connected in series; mirror resistors (Rci) are successively connected in series to form a mirror resistor chain; and the body of each switching transistor (Mi) is connected to an intermediate wiring end (C1) of a corresponding dynamic adjustment unit (DAi), and a first side wiring end (C2) and a second side wiring end (C3) of each dynamic adjustment unit (DAi) are respectively connected across to two ends in symmetric correspondence of at least one series resistor in the mirror resistor chain.

FIG. 2

## Description

## BACKGROUND

**Technical Field**

The present invention relates to the technical field of radio frequency (RF) integrated circuits, and in particular, to a high-linearity RF switch circuit, a chip including the RF switch circuit, and a corresponding electronic device.

**Related Art**

In the field of communications technologies, as one of the important components of a radio frequency (RF) front-end module, an RF switch circuit is configured to accurately switch and control a transmission path of an RF signal, select a corresponding RF path, and receive/transmit the RF signal in a case that a wireless communication system shares an antenna.

With the rapid development of the 5th generation (5G) mobile communication technology, increasingly high-performance requirements are imposed on the RF switch circuit. Generally, the RF signal in a high band produces an increased attenuation in space transmission. Therefore, to meet a stability requirement of the RF signal at a receiving end, a transmission power of the RF signal at a transmitting end needs to be increased, which requires the RF switch circuit to have a higher withstanding power. In addition, in the RF front-end module, in a case that an antenna is used for tuning to improve antenna efficiency, the RF switch circuit needs to withstand a very high operating voltage, which requires the RF switch circuit to have a higher voltage withstanding capability.

## SUMMARY

A primary technical problem to be solved in the present invention is to provide a radio frequency (RF) switch circuit having high voltage withstanding and high linearity.

Another technical problem to be resolved in the present invention is to provide a chip including the foregoing RF switch circuit and a corresponding electronic device.

To achieve the foregoing objectives, the present invention adopts the following technical solutions.

According to a first aspect of an embodiment of the present invention, an RF switch circuit is provided, including a plurality of stages of switch transistor units connected in series, where the switch transistor unit in each stage includes a switch transistor, a gate bias resistor, a bulk bias resistor, a path resistor, a mirror resistor, and a dynamic adjustment unit.

A gate of each switch transistor is connected to the corresponding gate bias resistor, a drain and a source of each switch transistor are respectively connected to the corresponding path resistors, and a bulk of each switch transistor is connected to the corresponding bulk bias resistor.

After the gate bias resistors in the stages of switch transistor units are connected in series to each other in sequence, a last gate bias resistor is connected to a gate bias voltage; after the bulk bias resistors in the stages of switch transistor units are connected in series to each other in sequence, a last bulk bias resistor is connected to the bulk bias voltage; and the mirror resistors are connected in series to each other in sequence to form a mirror resistor chain.

The bulk of each switch transistor is connected to an intermediate terminal of the corresponding dynamic adjustment unit, and a first side terminal and a second side terminal of the dynamic adjustment unit are respectively symmetrically connected across two ends of at least one corresponding series resistor in the mirror resistor chain.

Preferably, the dynamic adjustment unit includes an even number of identical diodes. Half of the diodes are connected in series to form a first diode sequence, and a negative terminal of the first diode sequence is connected to the first side terminal; the other half of the diodes are connected in series to form a second diode sequence, and a negative terminal of the second diode sequence is connected to the second side terminal; and a positive terminal of the first diode sequence and a positive terminal of the second diode sequence are connected to each other and then connected to the intermediate terminal.

Preferably, the dynamic adjustment unit includes an even number of identical switch transistors. Drains and sources of half of the switch transistors are connected in series to form a first switch transistor sequence, and a source of the first switch transistor sequence is connected to the first side terminal; drains and sources of the other half of the switch transistors are connected in series to form a second switch transistor sequence, and a source of the second switch transistor sequence is connected to the second side terminal; and a drain of the first switch transistor sequence and a drain of the second switch transistor sequence are connected to each other and then connected to the intermediate terminal.

Preferably, the gate and the drain of each switch transistor are directly connected, to form a diode connection.

Preferably, in the dynamic adjustment unit, when a voltage difference between the first side terminal and the second side terminal is less than a first predetermined voltage value, a voltage of the intermediate terminal is not affected by a voltage of the first side terminal and a voltage of the second side terminal; and when the voltage difference between the first side terminal and the second side terminal is greater than a second predetermined voltage value, the voltage of the intermediate terminal is adjusted to be close to a smaller one of the voltage of the first side terminal and the voltage of the second side terminal.

Preferably, each of the mirror resistors and the corresponding path resistor satisfy the following proportional relationship:

$$R_{ci}=k \times R_{dsi},$$

where $i$ is a positive integer and $1 \leq i \leq n$, $R_{ci}$ is a resistance value of a mirror resistor in an $i^{th}$-stage switch transistor unit, $R_{dsi}$ is a resistance value of a path resistor in the $i^{th}$-stage switch transistor unit, and $k$ is a proportionality coefficient.

Preferably, the gate of each switch transistor is connected to one end of the corresponding gate bias resistor, another end of the gate bias resistor is directly connected to the gate bias voltage, the bulk of each switch transistor is connected to one end of the corresponding bulk bias resistor, and another end of the bulk bias resistor is directly connected to the bulk bias voltage.

Preferably, in the plurality of stages of switch transistor units connected in series, a source of the switch transistor in a current stage is connected to a drain of the switch transistor in a next stage.

According to a second aspect of an embodiment of the present invention, an integrated circuit chip is provided. The integrated circuit chip includes the foregoing RF switch circuit.

According to a third aspect of an embodiment of the present invention, an electronic device is provided. The electronic device includes the foregoing RF switch circuit.

Compared with the prior art, the RF switch circuit provided in the present invention not only adopts the technical solution that the intermediate terminal of the dynamic adjustment unit is respectively connected to the bulks of the switch transistors in the stages, but also adopts the mirror resistor chain to connect to the signal input terminal and the signal output terminal of the RF switch circuit. In addition, the technical solution that the first side terminal and the second side terminal of the dynamic adjustment unit are respectively connected to at least one resistor in the mirror resistor chain effectively improves the problem of uneven distribution of the voltage swing in the stacked chain of the switch transistors in the stages, thereby improving the problem of nonlinearity of the RF switch circuit and significantly improving the power withstanding and voltage withstanding capabilities. Therefore, the RF switch circuit provided in the present invention has beneficial effects of an ingenious structure design, low production costs, a small chip size, and an excellent operating performance.

## BRIEF DESCRIPTION OF THE DRAWINGS

FIG. 1 is a schematic circuit diagram of a typical radio frequency (RF) switch circuit in the prior art.

FIG. 2 is a schematic circuit diagram of an RF switch circuit in an embodiment of the present invention.

FIG. 3(a), FIG. 3(b), and FIG. 3(c) are respectively schematic circuit diagrams of a dynamic adjustment unit in embodiments of the present invention.

FIG. 4 is a schematic circuit diagram of an RF switch circuit in another embodiment of the present invention.

FIG. 5 is a schematic circuit diagram of an RF switch circuit in still another embodiment of the present invention.

FIG. 6 is a comparison diagram of a simulation test of second-order harmonics of an RF switch circuit in the present invention.

FIG. 7 is a comparison diagram of a simulation test of third-order harmonics of an RF switch circuit in the present invention.

FIG. 8 is a schematic diagram of an electronic device using an RF switch circuit according to the present invention.

## DETAILED DESCRIPTION

Technical solutions of the present invention are further described in detail below with reference to drawings and specific embodiments.

To describe the technical solutions of the present invention more clearly, the inventor first analyzes in detail a problem existing in a typical radio frequency (RF) switch circuit in the prior art.

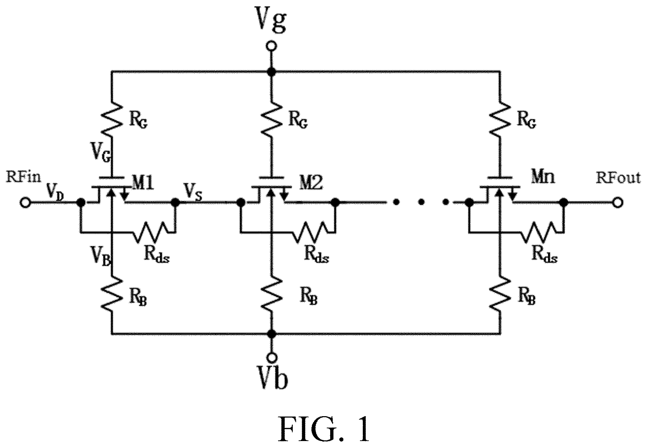

In the prior art, a method for improving power withstanding and voltage withstanding capabilities of an RF switch circuit is generally a transistor stacking method. In the method, the RF switch circuit includes a plurality of stages of switch transistor units connected in series. A typical circuit thereof is shown in FIG. 1. The RF switch circuit includes switch transistors M1, M2, ..., and Mn (n being a positive integer, and n ≥ 3) connected in series. A drain of the switch transistor M1 is connected to a signal input terminal RFin of the RF switch circuit. A source of the switch transistor Mn is connected to a signal output terminal RFout of the RF switch circuit. A gate bias voltage Vg is separately connected to a gate of each switch transistor through each gate bias resistor $R_G$. A bulk bias voltage Vb is separately connected to a bulk of each switch transistor through each bulk bias resistor $R_B$. A path resistor Rds is connected in parallel between a drain and a source of each switch transistor. Although the RF switch circuit can improve the power withstanding and voltage withstanding capabilities, problems still exist in two aspects. In one aspect, a voltage swing of the RF switch circuit is unevenly distributed in a stacked chain of the switch transistor, which leads to limitation on the improvement of the power withstanding and voltage withstanding capabilities of the RF switch circuit. In the other aspect, an increase in a quantity of switch transistors stacked in the RF switch circuit results in an increase in an insertion loss and an increase in an area of a chip occupied by the RF switch circuit.

As shown in FIG. 1, when the RF switch circuit is in an off state, a voltage difference between a source and a drain of each of the series-connected transistors in the stages often exhibits an uneven distribution due to differences in performance of components and devices and factors such as a circuit structure. In addition, with an increase in an input power of the RF signal, a voltage difference between the drain or the source and a bulk of each of the transistors in the stages gradually increases.

Specifically, in one aspect, when a drain voltage $V_D$ of the transistor rises and starts to be greater than 0 and reaches a specific value, a reverse PN junction between the drain and the bulk is caused to generate a direct current (DC). The DC generates a voltage drop across the bulk bias resistor $R_B$, thereby increasing a bulk voltage $V_B$. When a voltage difference between the bulk and the source of the transistor rises and reaches a specific value, a PN junction between the bulk and the source is turned on, causing the RF switch circuit to rapidly generate a large quantity of harmonics, and resulting in a serious nonlinear phenomenon, which seriously reduces the power withstanding and voltage withstanding capabilities of the RF switch circuit.

In the other aspect, when the drain voltage $V_D$ of the transistor decreases and starts to be less than 0 and reaches a specific value, a reverse PN junction between the source and the bulk is caused to generate a DC. The DC generates a voltage drop across the bulk bias resistor $R_B$, thereby increasing the bulk voltage $V_B$. When a voltage difference between the bulk and the drain of the transistor rises and reaches a specific value, a PN junction between the bulk and the drain is turned on, causing the RF switch circuit to rapidly generate a large quantity of harmonics, and resulting in a serious nonlinear phenomenon, which seriously reduces the power withstanding and voltage withstanding capabilities of the RF switch circuit.

It may be learned that the RF switch circuit using the transistor stacking method shown in FIG. 1 has an uneven distribution of the voltage swing of the RF switch circuit in the stacked chain of the switch transistor, which leads to an increase in the nonlinear phenomena and a decrease in the power withstanding and voltage withstanding capabilities of the RF switch circuit.

To resolve the problem existing in the foregoing RF switch circuit, an embodiment of the present invention provides an RF switch circuit. The RF switch circuit includes n (n being a positive integer and n ≥ 3) stages of switch transistor units connected in series, including a first-stage (that is, an initial-stage) switch transistor unit, n-2 intermediate-stage switch transistor units, and an $n^{th}$-stage (that is, a final-stage) switch transistor unit. An input terminal (that is, a drain, the same below) of the first-stage switch transistor unit is connected to the signal input terminal RFin of the RF switch circuit. An output terminal (that is, a source, the same below) of the first-stage switch transistor unit is connected to an input terminal of a second-stage switch transistor unit. An output terminal of the second-stage switch transistor unit is connected to an input terminal of a third-stage switch transistor unit, and so on. The n-2 intermediate-stage switch transistor units are connected in series to each other in sequence. An output terminal (that is, a source) of an $(n-1)^{th}$-stage switch transistor unit is connected to an input terminal (that is, a drain) of an $n^{th}$-stage (a final-stage) switch transistor unit. An output terminal of the $n^{th}$-stage (that is, a final-stage) switch transistor unit is connected to the signal output terminal RFout of the RF switch circuit.

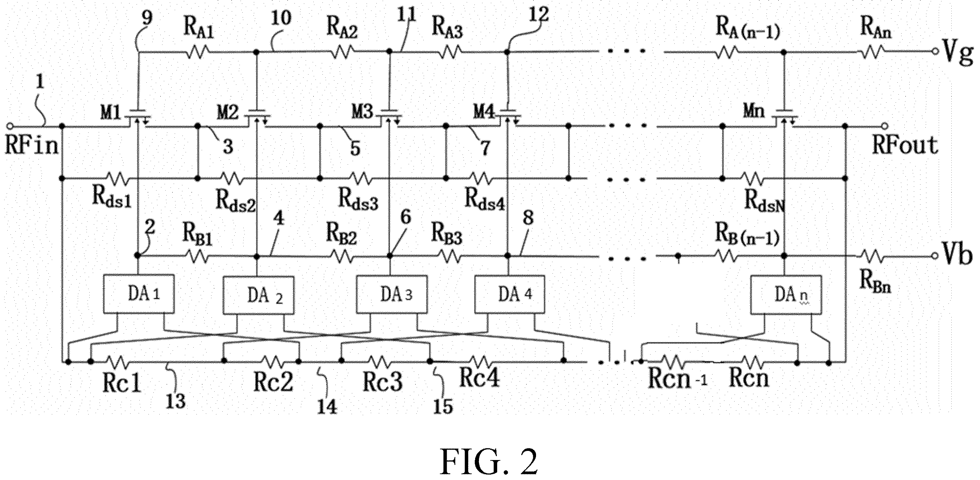

As shown in FIG. 2, in the n stages of switch transistor units, the switch transistor unit in each stage has a same circuit structure, including a switch transistor, a gate bias resistor, a bulk bias resistor, a path resistor, a mirror resistor, and a dynamic adjustment unit. In other words, in an embodiment of the present invention, the RF switch circuit includes: a first switch transistor M1, a second switch transistor M2, a third switch transistor M3, ..., and an $n^{th}$ switch transistor Mn; a first gate bias resistor $R_{A1}$, a second gate bias resistor $R_{A2}$, a third gate bias resistor $R_{A3}$, ..., and an $n^{th}$ gate bias resistor $R_{An}$; a first bulk bias resistor $R_{B1}$, a second bulk bias resistor $R_{B2}$, a third bulk bias resistor $R_{B3}$, ..., and an $n^{th}$ bulk bias resistor $R_{Bn}$; a first path resistor $R_{ds1}$, a second path resistor $R_{ds2}$, a third path resistor $R_{ds3}$, ..., and an $n^{th}$ path resistor $R_{dsn}$; a first mirror resistor $R_{c1}$, a second mirror resistor $R_{c2}$, a third mirror resistor $R_{c3}$, ..., and an $n^{th}$ mirror resistor $R_{cn}$; and a first dynamic adjustment unit DA1, a second dynamic adjustment unit DA2, a third dynamic adjustment unit DA3, ..., and an $n^{th}$ path dynamic adjustment unit DAn. Each dynamic adjustment unit DA has three terminals, which are respectively an intermediate terminal C1, a first side terminal C2, and a second side terminal C3.

In the n stages of switch transistor units, the gate of each switch transistor Mi (i being a positive integer and 1 ≤ i ≤ n) is connected to the corresponding gate bias resistor $R_{Ai}$. After the gate bias resistors $R_{Ai}$ in the stages of switch transistor units are connected in series to each other in sequence, a last gate bias resistor (that is, the gate bias resistor connected to the gate of the $n^{th}$-stage switch transistor) is connected to the gate bias voltage Vg. The drain and the source of each switch transistor Mi are separately connected to the corresponding path resistor $R_{dsi}$. A bulk of each switch transistor Mi is connected to the corresponding bulk bias resistor $R_{Bi}$. After the bulk bias resistors $R_{Bi}$ in the stages of switch transistor units are connected in series to each other in sequence, a last bulk bias resistor (that is, the bulk bias resistor connected to the gate of the $n^{th}$-stage switch transistor) is connected to the bulk bias voltage Vb. In addition, n mirror resistors $R_{ci}$ are connected in series to each other in sequence to form a mirror resistor chain. A first mirror resistor in the mirror resistor chain is connected to the signal input terminal RFin of the RF switch circuit, and a last mirror resistor in the mirror resistor chain is connected to the signal output terminal RFout of the RF switch circuit.

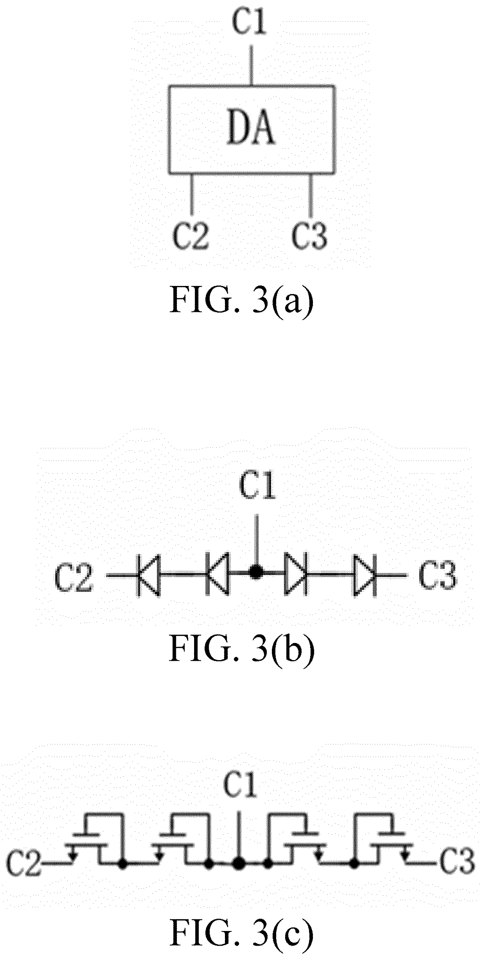

As shown in FIG. 3(a), in the n stages of switch transistor units, the bulk of each switch transistor Mi (i being a positive integer and $1 \leq i \leq n$) is connected to the intermediate terminal C1 of a corresponding dynamic adjustment unit DAi. The first side terminal C2 and the second side terminal C3 of the dynamic adjustment unit DAi are respectively connected across two ends of three series resistors in the mirror resistor chain, that is, an $(i-1)^{th}$ mirror resistor $R_{ci-1}$, an $i^{th}$ mirror resistor $R_{ci}$, and an $(i+1)^{th}$ mirror resistor $R_{ci+1}$. It should be noted that a connection manner of the first dynamic adjustment unit DA1 corresponding to a first-stage switch transistor unit and the $n^{th}$ dynamic adjustment unit DAn corresponding to a final-stage switch transistor unit is different from a connection manner of the dynamic adjustment unit DAi corresponding to an intermediate-stage switch transistor unit. The mirror resistor chain connected across the first side terminal C2 and the second side terminal C3 of the first dynamic adjustment unit DA1 includes two series resistors. The two series resistors are respectively the first mirror resistor $R_{c1}$ and the second mirror resistor $R_{c2}$. The mirror resistor chain connected across the first side terminal C2 and the second side terminal C3 of the $n^{th}$ dynamic adjustment unit DAn also includes two series resistors. The two series resistors are respectively the $(n-1)^{th}$ mirror resistor $R_{cn-1}$ and the $n^{th}$ mirror resistor $R_{cn}$.

As shown in FIG. 3(b), in an embodiment of the present invention, the dynamic adjustment unit includes four identical diodes. Two diodes are connected in series (that is, connected back to back) to form a first diode sequence, and a negative terminal of the first diode sequence is connected to the first side terminal C2. The other two diodes are connected in series to form a second diode sequence, and a negative terminal of the second diode sequence is connected to the second side terminal C3. A positive terminal of the first diode sequence and a positive terminal of the second diode sequence are connected to each other and then connected to the intermediate terminal C1.

As shown in FIG. 3(c), in another embodiment of the present invention, the dynamic adjustment unit includes four identical switch transistors. Each switch transistor uses the diode connection. In other words, the gate and the drain of the switch transistor are directly connected. Drains and sources of two switch transistors are connected in series to form a first switch transistor sequence, and a source of the first switch transistor sequence is connected to the first side terminal C2. Drains and sources of the other two switch transistors are connected in series to form a second switch transistor sequence, and a source of the second switch transistor sequence is connected to the second side terminal C3. A drain of the first switch transistor sequence and a drain of the second switch transistor sequence are connected to each other and then connected to the intermediate terminal C1.

It should be noted that a specific circuit structure of the dynamic adjustment unit DA is not limited to the foregoing embodiments. In another embodiment of the present invention, the dynamic adjustment unit may also include six, eight, or other even numbers of diodes. Similarly, in another embodiment of the present invention, the dynamic adjustment unit may also include six, eight, or other even numbers of switch transistors. In addition, in the embodiment shown in FIG. 2, the first side terminal C2 and the second side terminal C3 of the dynamic adjustment unit corresponding to the intermediate-stage switch transistor unit are symmetrically connected across two ends of the three series resistors in the mirror resistor chain, respectively. In another embodiment of the present invention, according to a specific requirement of a performance indicator of the RF switch circuit, the first side terminal C2 and the second side terminal C3 of the dynamic adjustment unit may also be symmetrically connected across two ends of at least one resistor or two or more series resistors in the mirror resistor chain, respectively.

The operating principle of the foregoing dynamic adjustment unit is as follows. When a voltage difference between the first side terminal C2 and the second side terminal C3 is less than the first predetermined voltage value, a corresponding current branch is not turned on, and a voltage of the intermediate terminal C1 is substantially unaffected by the voltage of the first side terminal C2 and the voltage of the second side terminal C3. When the voltage difference between the first side terminal C2 and the second side terminal C3 is greater than a second predetermined voltage value, a certain current branch with a relatively low voltage withstanding capability is instantaneously turned on. As a result, the voltage of the intermediate terminal C1 is adjusted to be close to a smaller one of the voltage of the first side terminal C2 and the voltage of the second side terminal C3 (only differing from each other by a turn-on voltage of a plurality of corresponding diodes or switch transistors).

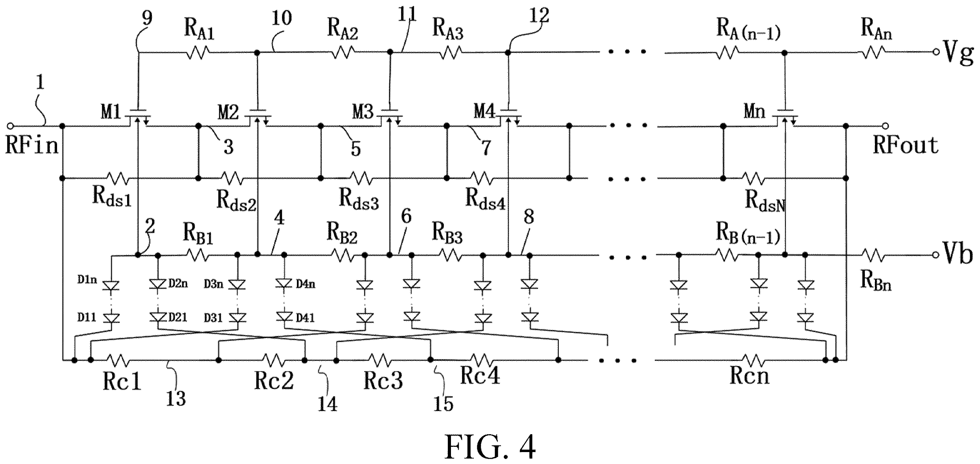

As shown in FIG. 4, in another embodiment of the present invention, the RF switch circuit includes n (n being a positive integer and $n \geq 3$) stages of switch transistor units connected in series, including a first-stage (that is, an initial-stage) switch transistor unit, n-2 intermediate-stage switch transistor units, and an $n^{th}$-stage (that is, a final-stage) switch transistor unit. In the stages of switch transistor units, the circuit structure of the dynamic adjustment unit in each switch transistor unit adopts the technical solution shown in FIG. 3(b). In other words, each dynamic adjustment unit includes four identical diodes. The intermediate terminal C1 of each dynamic adjustment unit is respectively connected to the bulk of a corresponding switch transistor. The first side terminal C2 and the second side terminal C3 are symmetrically connected across two ends of three mirror resistor segments in the mirror resistor chain. In the dynamic adjustment unit of the first-stage switch transistor unit and the $n^{th}$-stage (that is, the final-stage) switch transistor unit, the first side terminal C2 and the second side terminal C3 are respectively connected across two ends of two mirror resistor segments in the mirror resistor chain.

An operating principle of the RF switch circuit provided by the foregoing embodiments is analyzed and described in detail below.

As shown in FIG. 4, when the RF switch circuit is in an on state, the switch transistors M1, M2, M3, ..., and Mn in the n stages of switch transistor units are all in the on state, and the DC voltage of the gates of the switch transistors M1, M2, M3, ..., and Mn is the gate bias voltage Vg. The gate bias voltage Vg is a positive value. In other words, the DC voltage at a node 9, a node 10, a node 11, and the like is Vg. The DC voltage of the bulks of the switch transistors M1, M2, M3, ..., and Mn is the bulk bias voltages Vb. In this case, the bulk bias voltage Vb is 0. The gate bias voltage Vg is a positive value. In other words, the DC voltage at the node 2, the node 4, the node 6, and the like is 0. The DC voltage of the drain and the source of the switch transistors M1, M2, M3, ..., and Mn is 0. In other words, the DC voltage at a node 1, a node 3, a node 5, a node 7, and the like is 0. In this case, a turn-on resistance between the signal input terminal RFin and the signal output terminal RFout of the RF switch circuit is excessively small, and the voltage of the signal input terminal RFin is approximately equal to the voltage of the signal output terminal RFout. Therefore, all the diodes in each dynamic adjustment unit are turned off. In other words, diodes D11, D1n, D21, D2n, D31, D3n, D41, D4n, and the like are all in an off state. Therefore, the dynamic adjustment unit does not affect an operating performance of the RF switch circuit in the on state.

As shown in FIG. 4, when the RF switch circuit is in an off state, the switch transistors M1, M2, M3, ..., and Mn in the n stages of switch transistor units are all in the off state, and a DC voltage of the gate of the switch transistors M1, M2, M3, ..., and Mn is the gate bias voltage Vg. The gate bias voltage Vg is a negative value. In other words, the DC voltage at a node 9, a node 10, a node 11, and the like is Vg. The DC voltage of the bulks of the switch transistors M1, M2, M3, ..., and Mn is the bulk bias voltages Vb. In this case, the bulk bias voltage Vb is the negative value. The gate bias voltage Vg is a positive value. In other words, the DC voltage at the node 2, the node 4, the node 6, and the like is Vb. The DC voltage of the drain and the source of the switch transistors M1, M2, M3, ..., and Mn is 0. In other words, the DC voltage at a node 1, a node 3, a node 5, a node 7, and the like is 0. In addition, the DC voltage at a node 13, a node 14, a node 15, and the like in the mirror resistor chain is also 0. Therefore, when no RF signal is inputted into the signal input terminal RFin of the RF switch circuit, all the diodes in each dynamic adjustment unit are turned off. In other words, the diodes D11, D1n, D21, D2n, D31, D3n, D41, D4n, and the like are all in the off state.

In this case, when an RF signal is inputted into the signal input terminal RFin of the RF switch circuit, alternating current (AC) voltages of the drain and the source of the switch transistors M1, M2, M3, ..., and Mn are not equal because the switch transistors M1, M2, M3, ..., and Mn are all in the off state. In other words, the AC voltages at the node 1, the node 3, the node 5, the node 7, and the like are not equal (that is, the voltage distribution is uneven). In addition, in a direction from the signal input terminal RFin to the signal output terminal RFout, the AC voltages at the node 1, the node 3, the node 5, the node 7, and the like gradually decrease successively as a result of a voltage loss on a device. In this case, two ends of the mirror resistor chain are respectively connected to the signal input terminal RFin and the signal output terminal RFout of the RF switch circuit. Therefore, AC voltages at the node 13, the node 14, the node 15, and the like on the mirror resistor chain also gradually decrease successively.

In an embodiment of the present invention, through optimization design of resistance values of n mirror resistors $R_{c1}$ to $R_{cn}$, the resistance values of the n mirror resistors $R_{c1}$ to $R_{cn}$ and resistance values of corresponding n path resistors $R_{ds1}$ to $R_{dsn}$ satisfy the proportional relationship as follows:

$$R_{ci}=k\times R_{dsi} \qquad (1)$$

where i is a positive integer and $1 \leq i \leq n$, $R_{ci}$ is a resistance value of a mirror resistor in an $i^{th}$-stage switch transistor unit, $R_{dsi}$ is a resistance value of a path resistor in the $i^{th}$-stage switch transistor unit, and k is a proportionality coefficient with a preferred value range of 0.5 to 3.

When the above formula (1) is satisfied, the voltages of the drain and the source of the switch transistors M1, M2, M3, ..., and Mn may be made respectively equal to terminal voltages of their corresponding mirror resistors. A description is provided below by using the switch transistors in first three stages in the n stages of switch transistor units as an example. The same applies to the switch transistors in the other stages.

$$V3=V13 \qquad (2)$$

$$V5 = V14 \qquad\qquad (3)$$

$$V7 = V15 \qquad\qquad (4)$$

V3 is a voltage at the node 3, V13 is a voltage at the node 13, V5 is a voltage at the node 5, V14 is a voltage at the node 14, V7 is a voltage at the node 7, and V15 is a voltage at the node 15.

A description is provided below by using the switch transistor in a second stage in the n stages of switch transistor units as an example. The same applies to the switch transistors in the other stages.

A bulk voltage of the switch transistor M2, that is, the voltage V4 at the node 4, is as follows:

$$V4 = Vb + (V3 + V5)/2 \qquad\qquad (5)$$

The following may be obtained based on Formula (2) and Formula (3):

$$V4 = Vb + (V13 + V14)/2 \qquad\qquad (6)$$

where Vb is a bulk bias voltage.

A voltage $V_{D3}$ across two ends of series diodes D3n and D31 is as follows:

$$V_{D3} = V4 - V1 \qquad\qquad (7)$$

where V1 is the voltage at the node 1.

A voltage $V_{D4}$ across two ends of series diodes D4n and D41 is as follows:

$$V_{D4} = V4 - V15 \qquad\qquad (8)$$

It is assumed that a turn-on voltage of the series diodes D3n and D31 is $Vt_{D3}$, and a turn-on voltage of the series diodes D4n and D41 is $Vt_{D4}$. In a period of the RF signal, a signal voltage has a positive peak voltage and a negative peak voltage. Therefore, when the RF signal is in a positive half period, the voltage at the node 1 is greater than the voltage at the node 15, that is, V1 > V15. In this case, $V_{D3}$ is less than $Vt_{D3}$, and $V_{D4}$ is greater than $Vt_{D4}$. The series diodes D3n and D31 are in an off state, and the series diodes D4n and D41 are in an on state. Correspondingly, $V_{D4} = Vt_{D4}$. According to Formula (8), the voltage V4 at the node 4 is pulled to a relatively low voltage (V15 + $Vt_{D4}$). When the RF signal is in a negative half period, the voltage at the node 15 is greater than the voltage at the node 1, that is, V1 < V15. In this case, $V_{D3}$ is greater than $Vt_{D3}$, $V_{D4}$ is less than $Vt_{D4}$, and the series diodes D3n and D31 are in the on state. Correspondingly, $V_{D3} = Vt_{D3}$, and the series diodes D4n and D41 are in the off state. According to Formula (7), the voltage V4 at the node 4 is pulled to a relatively low voltage (V1 + $Vt_{D3}$). In this way, the bulk voltage of the switch transistor is pulled to a lower voltage through turn-on or turn-off of the first diode sequence and the second diode sequence connected to the bulk of the switch transistor. Through the foregoing technical solution, non-linearity of the RF switch circuit as a result of turn-on of the PN junction between the bulk and the drain or the source of the switch transistor is effectively improved, and the power withstanding and voltage withstanding capabilities are improved.

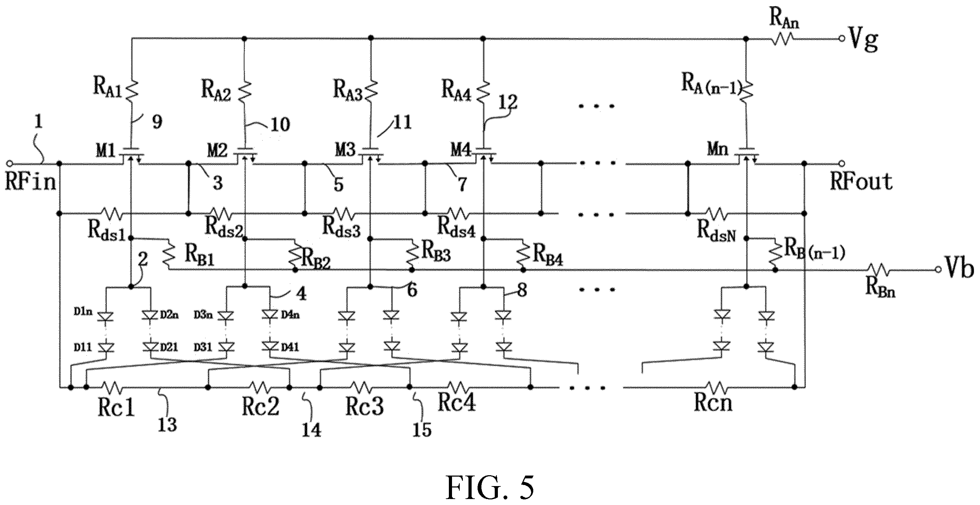

As shown in FIG. 5, in still another embodiment of the present invention, the RF switch circuit includes n (n being a positive integer and n ≥ 3) stages of switch transistor units connected in series, including a first-stage (that is, an initial-stage) switch transistor unit, n-2 intermediate-stage switch transistor units, and an n$^{th}$-stage (that is, a final-stage) switch transistor unit. This RF switch circuit is the same as the RF switch circuit in the embodiment shown in FIG. 4, except those gates of n switch transistors M1, M2, M3, ..., and Mn are respectively connected to their corresponding gate bias resistors, and bulks of the n switch transistors M1, M2, M3, ..., and Mn are respectively connected to their corresponding bulk bias resistors in different manners.

Specifically, in the embodiment shown in FIG. 5, the gate of each switch transistor Mi (i being a positive integer and 1 ≤ i ≤ n) is connected to an end of the corresponding gate bias resistor $R_{Ai}$, and another end of each gate bias resistor $R_{Ai}$ is connected to the gate bias voltage Vg. Similarly, the bulk of each switch transistor Mi is connected to an end of the corresponding bulk bias resistor $R_{Bi}$, and another end of each bulk bias resistor $R_{Bi}$ is respectively connected to the bulk bias voltage Vb. Other aspects of the RF switch circuit in the foregoing embodiment, such as the circuit structure, the operating principle, and the circuit performance, are the same as those in the embodiment shown in FIG. 4.

It should be noted that, in a preferred embodiment of the present invention, the switch transistors M1 to Mn in the switch transistor unit are N-metal-oxide-semiconductor (NMOS) transistors, but are not limited thereto. Another type of switch transistor, such as a p-channel MOS (PMOS) transistor, may also be configured to implement the technical solutions of the present invention.

In addition, various embodiments or variant examples of the present invention are described in a related manner, and identical and similar parts among various embodiments or variant examples may be referred to each other. Each embodiment or variant example highlights a difference from another embodiment, but the embodiments and the variant examples are all implemented based on the operating principle of the RF switch circuit. Details are not described herein again.

To verify an excellent performance of the RF switch circuit provided in the embodiments of the present invention, the inventor performs two comparative simulation tests on a prior-art solution shown in FIG. 1 and the technical solution of the present invention shown in FIG. 4.

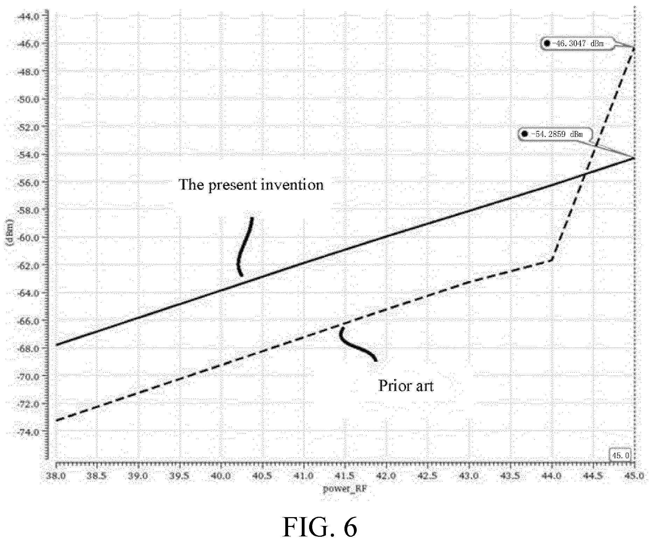

FIG. 6 shows a simulation test result of second-order harmonics of an RF switch circuit. An abscissa is an RF power, and an ordinate is a second-order harmonic value. It may be learned from FIG. 6 that when an inputted RF power reaches a certain power value, the RF switch circuit in the prior-art solution has a sudden harmonic change and a sharp nonlinear deterioration. However, in the RF switch circuit provided in the present invention, a harmonic characteristic is still within a range of a linear growth under a same inputted power value.

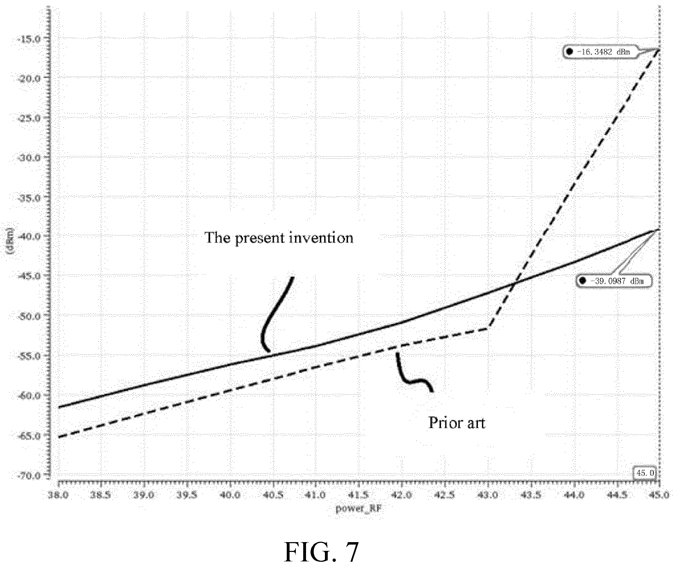

FIG. 7 shows a simulation test result of third-order harmonics of an RF switch circuit. An abscissa is an RF power, and an ordinate is a third-order harmonic value. It may be learned from FIG. 7 that when an inputted RF power reaches a certain power value, the RF switch circuit in the prior-art solution has a sudden harmonic change and a sharp nonlinear deterioration. However, in the RF switch circuit provided in the present invention, a harmonic characteristic is still within a range of a linear growth under a same inputted power value.

An embodiment of the present invention further provides an integrated circuit chip. The integrated circuit chip may be used as an RF front-end module, including the RF switch circuit provided in the foregoing embodiment. The integrated circuit chip is configured to accurately switch and control the transmission path of the RF signal, and to select a corresponding RF path. In a case that the wireless communication system shares the antenna, the corresponding RF front-end module may further include two parts: a receiving channel and a transmitting channel. A specific structure of the RF switch circuit in the integrated circuit chip is not repeated herein.

In addition, the RF switch circuit provided in the present invention may further be used in an electronic device, which is used as an important part of a communication assembly. The electronic device mentioned herein refers to a computer device that may be used in a mobile environment and support a plurality of communication standards such as GSM, EDGE, TD_SCDMA, TDD_LTE, FDD_LTE, and 5G. The computer device includes a mobile phone, a notebook computer, a tablet computer, an on-board computer, and the like. In addition, the technical solutions provided in the present invention are also applicable to an application of another communication assembly, such as a communication base station.

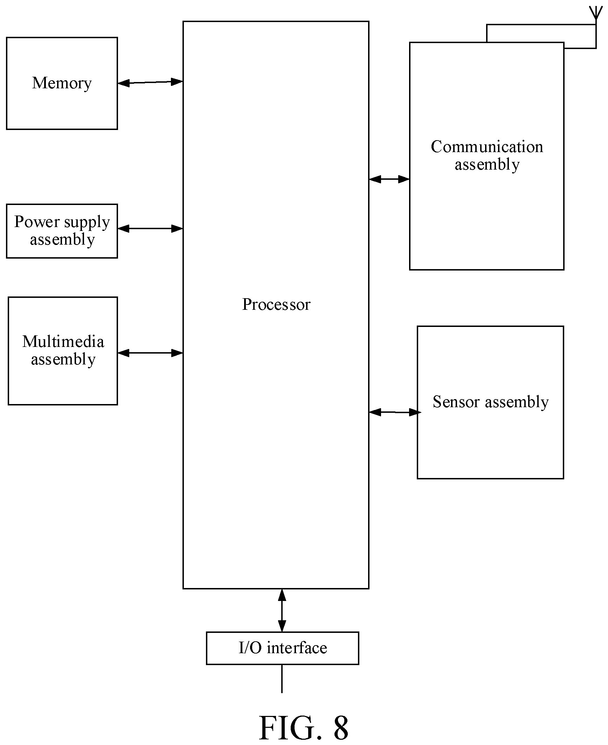

As shown in FIG. 8, the electronic device includes at least a processor and a memory, and may further include a communication assembly, a sensor assembly, a power supply assembly, a multimedia assembly, and an input/output (I/O) interface according to an actual requirement. The memory, the communication assembly, the sensor assembly, the power supply assembly, the multimedia assembly, and the I/O interface are connected to the processor. The memory may be a static random access memory (SRAM), an electrically erasable programmable read only memory (EEPROM), an erasable programmable read only memory (EPROM), a programmable read only memory (PROM), a read only memory (ROM), a magnetic memory, a flash memory, and the like. The processor may be a central processing unit (CPU), a graphics processing unit (GPU), a field-programmable gate array (FPGA), an application specific integrated circuit (ASIC), a digital signal processing (DSP) chip, and the like. Another communication assembly, sensor assembly, power supply assembly, multimedia assembly, and the like may be implemented by using a general-purpose component. Details are not described herein.

It may be learned from a detailed description of the technical solutions of the present invention through the foregoing embodiments that the RF switch circuit provided in the present invention not only adopts the technical solution that the intermediate terminal of the dynamic adjustment unit is respectively connected to the bulks of the switch transistors in the stages, but also adopts the mirror resistor chain to connect to the signal input terminal and the signal output terminal of the RF switch circuit. In addition, the technical solution that the first side terminal and the second side terminal of the dynamic adjustment unit are respectively connected to at least one resistor in the mirror resistor chain effectively improves the problem of uneven distribution of the voltage swing in the stacked chain of the switch transistors in the stages, thereby improving the problem of nonlinearity of the RF switch circuit and significantly improving the power withstanding and voltage withstanding capabilities. Therefore, the RF switch circuit provided in the present invention has beneficial effects of an ingenious structure design, low production costs, a small chip size, and an excellent operating performance.

The high-linearity RF switch circuit, the chip, and the electronic device provided in the present invention are described in detail above. Any obvious change made by a person of ordinary skill in the art to the present invention without departing from the essence of the present invention shall fall within the protection scope of the patent right of the present invention.

**Claims**

1. A radio frequency (RF) switch circuit, comprising a plurality of stages of switch transistor units connected in series, wherein the switch transistor unit in each stage comprises a switch transistor, a gate bias resistor, a bulk bias resistor, a path resistor, a mirror resistor, and a dynamic adjustment unit, wherein

   a gate of each switch transistor is connected to the corresponding gate bias resistor, a drain and a source of each switch transistor are respectively connected to the corresponding path resistors, and a bulk of each switch transistor is connected to the corresponding bulk bias resistor;

   after the gate bias resistors in the stages of switch transistor units are connected in series to each other in sequence, a last gate bias resistor is connected to a gate bias voltage; after the bulk bias resistors in the stages of switch transistor units are connected in series to each other in sequence, a last bulk bias resistor is connected to the bulk bias voltage; the mirror resistors are connected in series to each other in sequence to form a mirror resistor chain; and

   the bulk of each switch transistor is connected to an intermediate terminal of the corresponding dynamic adjustment unit, and a first side terminal and a second side terminal of the dynamic adjustment unit are respectively symmetrically connected across two ends of at least one corresponding series resistor in the mirror resistor chain.

2. The RF switch circuit according to claim 1, wherein
   the dynamic adjustment unit comprises an even number of identical diodes; half of the diodes are connected in series to form a first diode sequence, and a negative terminal of the first diode sequence is connected to the first side terminal; the other half of the diodes are connected in series to form a second diode sequence, and a negative terminal of the second diode sequence is connected to the second side terminal; and a positive terminal of the first diode sequence and a positive terminal of the second diode sequence are connected to each other and then connected to the intermediate terminal.

3. The RF switch circuit according to claim 1, wherein
   the dynamic adjustment unit comprises an even number of identical switch transistors; drains and sources of half of the switch transistors are connected in series to form a first switch transistor sequence, and a source of the first switch transistor sequence is connected to the first side terminal; drains and sources of the other half of the switch transistors are connected in series to form a second switch transistor sequence, and a source of the second switch transistor sequence is connected to the second side terminal; and a drain of the first switch transistor sequence and a drain of the second switch transistor sequence are connected to each other and then connected to the intermediate terminal.

4. The RF switch circuit according to claim 3, wherein
   the gate and the drain of each switch transistor are directly connected, to form a diode connection.

5. The RF switch circuit according to any of claims 2 to 4, wherein
   in the dynamic adjustment unit, when a voltage difference between the first side terminal and the second side terminal is less than a first predetermined voltage value, a voltage of the intermediate terminal is not affected by a voltage of the first side terminal and a voltage of the second side terminal; and when the voltage difference between the first side terminal and the second side terminal is greater than a second predetermined voltage value, the voltage of the intermediate terminal is adjusted to be close to a smaller one of the voltage of the first side terminal and the voltage of the second side terminal.

6. The RF switch circuit according to claim 1, wherein

   each of the mirror resistors and the corresponding path resistor satisfy the following proportional relationship:

   $$R_{ci}=k \times R_{dsi},$$

   wherein i is a positive integer and $1 \leq i \leq n$, $R_{ci}$ is a resistance value of a mirror resistor in an $i^{th}$-stage switch transistor unit, $R_{dsi}$ is a resistance value of a path resistor in the $i^{th}$-stage switch transistor unit, and k is a proportionality coefficient.

7. The RF switch circuit according to claim 1, wherein

the gate of each switch transistor is connected to one end of the corresponding gate bias resistor, another end of the gate bias resistor is directly connected to the gate bias voltage, the bulk of each switch transistor is connected to one end of the corresponding bulk bias resistor, and another end of the bulk bias resistor is directly connected to the bulk bias voltage.

8. The RF switch circuit according to claim 1, wherein
in the plurality of stages of switch transistor units connected in series, a source of the switch transistor in a current stage is connected to a drain of the switch transistor in a next stage.

9. An integrated circuit chip, comprising the RF switch circuit according to any of claims 1 to 8.

10. An electronic device, comprising the RF switch circuit according to any of claims 1 to 8.

FIG. 1

FIG. 2

EP 4 560 921 A1

FIG. 3(a)

FIG. 3(b)

FIG. 3(c)

FIG. 4

FIG. 5

EP 4 560 921 A1

FIG. 6

FIG. 7

FIG. 8

## INTERNATIONAL SEARCH REPORT

| | International application No. |
|---|---|
| | **PCT/CN2023/107822** |

| A. | CLASSIFICATION OF SUBJECT MATTER |
|---|---|

H03K 17/687(2006.01)i;  H03K 17/10(2006.01)i

According to International Patent Classification (IPC) or to both national classification and IPC

| B. | FIELDS SEARCHED |
|---|---|

Minimum documentation searched (classification system followed by classification symbols)

IPC: H03K

Documentation searched other than minimum documentation to the extent that such documents are included in the fields searched

Electronic data base consulted during the international search (name of data base and, where practicable, search terms used)

CNTXT, WPABS, DWPI, CNKI: 体极, 体部, 体电极, 体区, 体端, 背栅, 底栅, 二极管, 电阻, 层叠, 堆叠, 晶体管, 射频, 天线, 开关, RF???, transistor? , stack+

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 114629479 A (PSEMI CORP.) 14 June 2022 (2022-06-14)<br>description, paragraphs [0043]-[0099], and figures 3-10 | 1-10 |
| PX | CN 115395936 A (SHANGHAI VANCHIP ELECTRONIC TECHNOLOGIES CO., LTD.) 25 November 2022 (2022-11-25)<br>claims 1-10, description, paragraphs [0039]-[0081], and figures 2-8 | 1-10 |
| A | CN 102474251 A (QUALCOMM INC.) 23 May 2012 (2012-05-23)<br>entire document | 1-10 |
| A | CN 103986449 A (TRIQUINT SEMICONDUCTOR, INC.) 13 August 2014 (2014-08-13)<br>entire document | 1-10 |
| A | CN 110719092 A (GUANGDONG UNIVERSITY OF TECHNOLOGY) 21 January 2020 (2020-01-21)<br>entire document | 1-10 |
| A | CN 111800112 A (INFINEON TECHNOLOGIES AG) 20 October 2020 (2020-10-20)<br>entire document | 1-10 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 September 2023** | **21 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
|---|
| **PCT/CN2023/107822** |

**C.    DOCUMENTS CONSIDERED TO BE RELEVANT**

| Category* | Citation of document, with indication, where appropriate, of the relevant passages | Relevant to claim No. |
|---|---|---|
| A | US 10447344 B2 (QORVO US, INC.) 15 October 2019 (2019-10-15)<br>entire document | 1-10 |
| A | US 10715133 B1 (QORVO US, INC.) 14 July 2020 (2020-07-14)<br>entire document | 1-10 |
| A | US 2014242760 A1 (RF MICRO DEVICES, INC.) 28 August 2014 (2014-08-28)<br>entire document | 1-10 |
| A | US 2022038097 A1 (PSEMI CORP.) 03 February 2022 (2022-02-03)<br>entire document | 1-10 |

Form PCT/ISA/210 (second sheet) (July 2022)

## INTERNATIONAL SEARCH REPORT
### Information on patent family members

International application No.

**PCT/CN2023/107822**

| Patent document cited in search report | | | Publication date (day/month/year) | Patent family member(s) | | | Publication date (day/month/year) |
|---|---|---|---|---|---|---|---|
| CN | 114629479 | A | 14 June 2022 | US | 2023246643 | A1 | 03 August 2023 |
| | | | | WO | 2022125274 | A1 | 16 June 2022 |
| | | | | US | 2022190826 | A1 | 16 June 2022 |
| | | | | US | 11601126 | B2 | 07 March 2023 |
| CN | 115395936 | A | 25 November 2022 | | None | | |
| CN | 102474251 | A | 23 May 2012 | WO | 2011014848 | A1 | 03 February 2011 |
| | | | | US | 2011025408 | A1 | 03 February 2011 |
| | | | | US | 8395435 | B2 | 12 March 2013 |
| | | | | JP | 2013501429 | A | 10 January 2013 |
| | | | | JP | 5559325 | B2 | 23 July 2014 |
| | | | | EP | 2460271 | A1 | 06 June 2012 |
| | | | | EP | 2460271 | B1 | 15 July 2015 |
| | | | | CN | 102474251 | B | 03 June 2015 |
| | | | | IN | 310890 | B | 12 April 2019 |
| | | | | IN | 201200604 | P4 | 15 March 2013 |
| CN | 103986449 | A | 13 August 2014 | KR | 20140101692 | A | 20 August 2014 |
| | | | | KR | 102121075 | B1 | 09 June 2020 |
| | | | | TW | 201433105 | A | 16 August 2014 |
| | | | | TWI | 675551 | B | 21 October 2019 |
| | | | | JP | 2014155227 | A | 25 August 2014 |
| | | | | JP | 6702646 | B2 | 03 June 2020 |
| | | | | US | 2014227983 | A1 | 14 August 2014 |
| | | | | US | 9214932 | B2 | 15 December 2015 |
| | | | | FR | 3002096 | A1 | 15 August 2014 |
| | | | | FR | 3002096 | B1 | 23 February 2018 |
| | | | | JP | 2018191351 | A | 29 November 2018 |
| | | | | JP | 6800926 | B2 | 16 December 2020 |
| | | | | CN | 103986449 | B | 26 March 2021 |
| CN | 110719092 | A | 21 January 2020 | | None | | |
| CN | 111800112 | A | 20 October 2020 | KR | 20200118369 | A | 15 October 2020 |
| | | | | KR | 102307441 | B1 | 01 October 2021 |
| | | | | US | 2020321957 | A1 | 08 October 2020 |
| | | | | US | 10931275 | B2 | 23 February 2021 |
| | | | | EP | 3720001 | A1 | 07 October 2020 |
| | | | | EP | 3720001 | B1 | 10 November 2021 |
| | | | | KR | 20210127888 | A | 25 October 2021 |
| | | | | KR | 102454354 | B1 | 14 October 2022 |
| | | | | US | 10680599 | B1 | 09 June 2020 |
| US | 10447344 | B2 | 15 October 2019 | US | 2017201245 | A1 | 13 July 2017 |
| | | | | US | 2017201244 | A1 | 13 July 2017 |
| | | | | US | 10454529 | B2 | 22 October 2019 |
| US | 10715133 | B1 | 14 July 2020 | US | 2020382114 | A1 | 03 December 2020 |
| | | | | US | 10998900 | B2 | 04 May 2021 |
| US | 2014242760 | A1 | 28 August 2014 | US | 8723260 | B1 | 13 May 2014 |
| US | 2022038097 | A1 | 03 February 2022 | US | 2022038092 | A1 | 03 February 2022 |
| | | | | WO | 2022035603 | A1 | 17 February 2022 |
| | | | | KR | 20230043983 | A | 31 March 2023 |
| | | | | CN | 116134731 | A | 16 May 2023 |
| | | | | DE | 112021004123 | T5 | 27 July 2023 |

Form PCT/ISA/210 (patent family annex) (July 2022)